# EUROPÄISCHE PATENTANMELDUNG

(11) **EP 1 014 508 A2**
(43) Veröffentlichungstag der Anmeldung: **28.06.2000**
(21) Anmeldenummer: 99122534.3
(22) Anmeldetag: 12.11.1999
(51) Int. Cl.: H01R 13/629, H01R 12/08, H01R 12/18

(54) **Steckbare Leiterplatte mit beweglicher Steckkontaktanordnung**

(30) Priorität: 21.12.1998 DE 19859228
(71) Anmelder: Siemens Nixdorf Retail and Banking Systems GmbH, 33106 Paderborn (DE)
(72) Erfinder: Baitz, Günter, 13629 Berlin (DE); Kamin, Hartmut, 10585 Berlin (DE)

(57) **Zusammenfassung**

Die Erfindung beschreibt eine steckbare Leiterplatte (10), bei der die Steckkontaktanordnung (60) auf einem gegenüber dem übrigen Leiterplattenteil (80) verschiebbaren Leiterplattenteil (70) angeordnet ist. Dadurch ist ein Lösen der Steckverbindung möglich, ohne den übrigen Leiterplattenteil (80) zu bewegen. Der verschiebbare Leiterplattenteil (70) ist über eine Schiebevorrichtung (100) und eine flexible Leiterbahnanordnung (110) mit dem übrigen Leiterplattenteil (80) verbunden.

## Beschreibung

Die Erfindung betrifft eine steckbare Leiterplatte mit einer längs einer ihrer Kanten vorgesehenen Steckkontaktanordnung.

In Rechnern mit besonders flachen Gehäusen, wie z.B. bei elektronischen Kassen, werden Erweiterungskarten, das sind steckbare Leiterplatten, nicht senkrecht auf eine Basisleiterplatte gesteckt, sondern parallel zu ihr angeordnet. Die Erweiterungskarten werden senkrecht auf eine Adapterkarte gesteckt, die ebenfalls eine steckbarie Leiterplatte ist und ihrerseits senkrecht auf die Basisleiterplatte gesteckt wird. Die Erweiterungskarten sind über Leitungen eines PC-Busses mit einer Zentraleinheit verbunden, die sich auf der Basisleiterplatte befindet. Bei den Erweiterungskarten handelt es sich z.B. um Netzwerkkarten, die für den Anschluß des Rechners an ein Netzwerk benötigt werden.

Um die Basisleiterplatte auszuwechseln, ist beim Stand der Technik der Ausbau aller Erweiterungskarten und der Adapterkarte notwendig. Dieser Vorgang ist sehr zeitaufwendig und erfordert zudem Fachkenntnis. Ein schnelles Wechseln der Basisleiterplatte ist vor allem bei wirtschaftlich wichtigen Rechnern, wie z.B. bei den bereits erwähnten elektronischen Kassen, notwendig, um die Ausfallzeit des Rechners und die damit verbundenen Störungen des Betriebsablaufes möglichst gering zu halten.

Aufgabe der Erfindung ist es, eine steckbare Leiterplatte anzugeben, die zum Lösen der Steckverbindung nicht ausgebaut werden muß.

Diese Aufgabe löst eine steckbare Leiterplatte mit den im Patentanspruch 1 angegebenen Merkmalen. Vorteilhafte Weiterbildungen der Erfindung sind Gegenstand der Unteransprüche.

Der Erfindung liegt die Idee zugrunde, daß eine Schiebevorrichtung, die einen den Steckkontakt tragenden Leiterplattenteil mit dem übrigen Leiterplattenteil verbindet, zum einen die notwendige Beweglichkeit ermöglicht, um die Steckverbindung zu lösen, und zum anderen stabil genug ist, um die Leiterplatte bei geschlossener Steckverbindung in einer z.B. aufrechten Position zu halten. Die Schiebevorrichtung erlaubt ausschließlich eine relative Bewegung der beiden Leiterplattenteile in Steckrichtung. Die Leiterbahnen werden zwischen den beiden Leiterplattenteilen über eine flexible Leiterbahnanordnung miteinander verbunden.

Der verschiebbare Leiterplattenteil, der die Steckkontaktanordnung trägt, und der übrige Leiterplattenteil können in beliebiger Position zueinander liegen. Eine besonders einfache und stabile Schiebevorrichtung ist möglich, wenn die beiden Leiterplattenteile in einer Ebene liegen.

Die erfindungsgemäße Leiterplatte ist besonders vorteilhaft als Adapterkarte einsetzbar, auf der sich Vorrichtungen zur Aufnahme weiterer steckbarer Leiterplatten befinden. Die auf der Leiterplatte eingesteckten weiteren Leiterplatten sind über einen PC-Bus mit einer zentralen Verarbeitungseinheit eines Rechners verbunden. Die vom verschiebbaren Leiterplattenteil getragene Steckkontaktanordnung ist in diesem Fall ein PC-Bus-Stecker, der zusammen mit einer Steckeraufnahme, die sich auf einer Basisleiterplatte befindet, eine PC-Bus-Steckverbindung bildet. Die erfindungsgemäße Leiterplatte gestattet ein einfaches und schnelles Auswechseln der Basisleiterplatte ohne zuvor die Adapterkarte und die auf ihr eingesteckten weiteren Leiterplatten auszubauen. Somit werden auch empfindliche Steckkontaktanordnungen der weiteren Leiterplatten geschont.

Bei einer vorteilhaften Weiterbildung enthält der übrige Leiterplattenteil eine Befestigungsvorrichtung, mit der die steckbare Leiterplatte z.B. an einem Gehäusesegment des Rechners befestigbar ist, so daß der übrige Leiterplattenteil auch bei gelöster Steckverbindung seine Lage nicht verändert. Eine solche Befestigungsvorrichtung kann beispielsweise ein Winkelelement sein, mit dem die steckbare Leiterplatte am Gehäusesegment verschraubt wird. Die Befestigungsvorrichtung ihrerseits sollte mit dem übrigen Leiterplattenteil stabil aber lösbar verbunden sein. Hierfür geeignet sind z.B. Schraub- oder Klemmverbindungen.

Die flexible Leiterbahnordnung, die Leitungen des übrigen Leiterplattenteiles mit der auf dem verschiebbaren Leiterplattenteil angeordneten Steckkontaktanordnung verbindet, kann z.B. mit Hilfe eines Flachbandkabels realisiert werden. Die Steckkontaktanordnung ist vorzugsweise als Steckkontaktleiste ausgebildet, bei der die Steckkontakte in zwei gegenüberliegenden Reihen angeordnet sind.

Eine vorteilhafte Weiterbildung sieht als Schiebevorrichtung Verbindungsplatten vor, die jeweils mindestens zwei Langlöcher enthalten, in denen jeweils ein auf dem übrigen Leiterplattenteil stehender Bolzen eingreift. Diese Schiebevorrichtung eignet sich insbesondere für steckbare Leiterplatten, bei denen der verschiebbare Leiterplattenteil und der übrige Leiterplattenteil im wesentlichen in einer Ebene liegen. Durch die Verwendung von Verbindungsplatten mit jeweils zwei Langlöchern wird die Führung des verschiebbaren Leiterplattenteiles verbessert. Die Stabilität der Leiterplatte wird durch die Verwendung von zwei Verbindungsplatten erhöht.

Besonders vorteilhaft ist die Verwendung einer Antriebsvorrichtung, die ein Bewegen des verschiebbaren Leiterplattenteils und damit ein Lösen und Schließen der Steckverbindung auch bei geschlossenem Gehäuse des Gerätes erlaubt. Der übrige Leiterplattenteil ist dabei z.B. mit einer Bodenplatte des Gerätes fest verbunden ist. Eine solche Antriebsvorrichtung beschleunigt das Auswechseln einer Basisleiterplatte, auf der die erfindungsgemäße Leiterplatte aufgesteckt ist, beispielsweise durch eine speziell dafür vorgesehene Gehäuseöffnung, weil das Gehäuse nicht demontiert werden muß. Zum anderen werden durch das geschlossene Gehäuse die Bauteile des Rechners auch während des Auswechselns der erfindungsgemäßen Leiterplatte geschützt. Zudem wird das Auswechseln der Basisleiterplatte so weit vereinfacht, daß keine besonderen Fachkenntnisse mehr erforderlich sind.

Bei einer Weiterbildung der Erfindung ist eine Antriebsvorrichtung vorgesehen, die zwei zweiarmige Hebel enthält, die in einer Ebene parallel zur Leiterplattenebene drehbar gelagert sind und die mit je einem ersten Hebelarm mit einem auf einer ersten bzw. zweiten Verbindungsplatte angeordneten Stift in Eingriff stehen. Eine Gelenkstange verbindet die zweiten Hebelarme der beiden Hebel miteinander. Ein Ende der Gelenkstange ist aus dem Gehäuse des Gerätes herausgeführt, so daß, wie bereits erwähnt, ein Lösen bzw. Schließen der Steckverbindung zwischen steckbarer Leiterplatte und Basisleiterplatte auch bei geschlossenem Gehäuse möglich ist. Diese Antriebsvorrichtung zeichnet sich durch einen einfachen Aufbau aus und ist vor allem für leicht lösbare Steckverbindungen geeignet.

Eine weitere Antriebsvorrichtung sieht ein an der ersten bzw. zweiten Verbindungsplatte befestigtes Lager für je eine Scheibe vor. Die Scheiben sitzen exzentrisch auf einer Welle, deren Längsachse im wesentlichen senkrecht zur Steckrichtung und in einer Ebene parallel zur Leiterplattenebene liegt. Bei dieser Antriebsvorrichtung ist ein Ende der Welle aus dem Gehäuse des Gerätes herausgeführt, so daß die Welle von außen, z.B. mit einem Stellrad, gedreht werden kann.

Besonders günstig ist es, diese Antriebsvorrichtung um ein an einem Ende der Welle sitzendes Getriebe zu erweitern, über das die Welle gedreht wird. Mit Hilfe des Getriebes wird die auf die Welle wirkende Kraft vergrößert, so daß sich mit dieser Weiterbildung insbesondere Steckverbindungen lösen lassen, bei denen die Steckkontaktanordnung sehr fest in der Steckeraufnahme sitzt. Ein solches Getriebe ist z.B. als Zahnradgetriebe ausgebildet.

Die folgende Beschreibung erläutert in Verbindung mit der beigefügten Zeichnung die Erfindung anhand zwei weiterer Ausführungsbeispiele. Darin zeigt:
- Figur 1: eine Seitenansicht einer steckbaren Leiterplatte,
- Figur 2: eine steckbare Leiterplatte mit Schneckengetriebe als Antriebsvorrichtung, und
- Figur 3: eine steckbare Leiterplatte mit Schubstange als Antriebsvorrichtung.

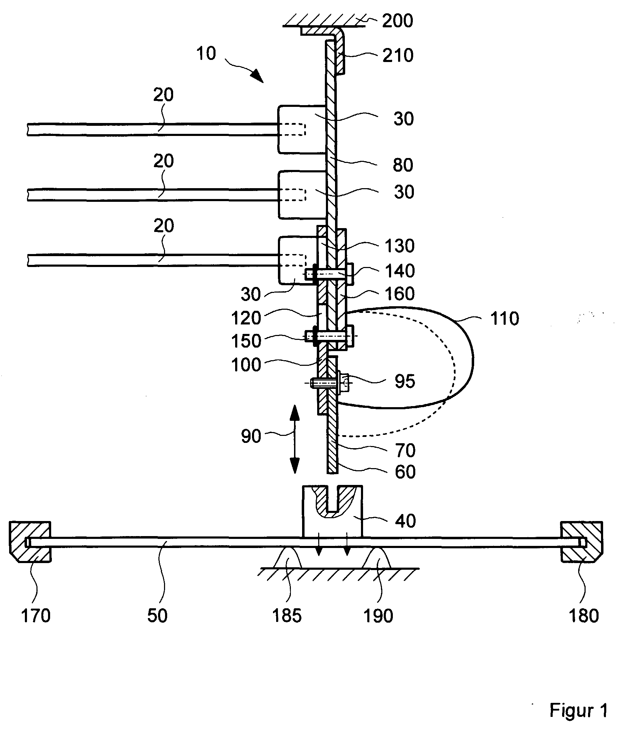

Figur 1 zeigt eine steckbare Leiterplatte 10 für einen Rechner, die als Adapterkarte für drei weitere Leiterplatten 20 verwendet wird. Jede der drei weiteren Leiterplatten 20 sitzt in einer Steckeraufnahme 30. Die drei weiteren Leiterplatten 20 sind über einen nicht näher dargestellten PC-Bus mit einer ebenfalls nicht dargestellten zentralen Verarbeitungseinheit, einer CPU des Rechners verbunden. Die Verarbeitungseinheit und eine PC-Bus-Steckeraufnahme 40 befinden sich auf einer Basisleiterplatte 50, die auch Motherboard genannt wird.

Eine Steckkontaktanordnung 60 wird von einem verschiebbaren Leiterplattenteil 70 getragen, das relativ zum übrigen Leiterplattenteil 80 in der durch einen Pfeil 90 angedeuteten Steckrichtung beweglich ist. Der verschiebbare Leiterplattenteil 70 ist mit einer Schraube 95 an einer Verbindungsplatte 100 befestigt. Die Verbindungsplatte 100 verbindet den verschiebbaren Leiterplattenteil 70 mit dem übrigen Leiterplattenteil 80. Ein Flachbandkabel 110 dient als flexible Leiterbahnanordnung, die hier nicht dargestellte Leitungen des PC-Busses mit der Steckkontaktanordnung 60 verbindet.

Die Verbindungsplatte 100 enthält ein erstes Langloch 120 sowie ein zweites Langloch 130 und wird durch Schrauben 140, 150, vorzugsweise Ansatzschrauben, mit dem übrigen Leiterplattenteil 80 und einem Plattensegment 160 verbunden. Das Plattensegment 160 gehört zu einer hier nicht gezeigten Befestigungsvorrichtung, mit der der übrige Leiterplattenteil 80 an einem Gehäuseabschnitt befestigt ist.

Die Langlöcher 120, 130 erstrecken sich in der durch den Pfeil 90 angegebene Steckrichtung. Die Verbindungsplatte 100 mit den Langlöchern 120 und 130 bildet zusammen mit den Schrauben 140 bzw. 150 eine Schiebevorrichtung.

In der Figur 1 ist die PC-Bus-Steckverbindung, zu der die Steckkontaktanordnung 60 und die Steckeraufnahme 40 gehören, gelöst. Schienen 170 bzw. 180 halten die Basisleiterplatte 50 und stellen sicher, daß nach dem Auswechseln der Basisleiterplatte 50 die Steckeraufnahme 40 genau unter dem verschiebbaren Leiterplattenteil 70 positioniert wird.

Ein erstes Widerlager 185 und ein zweites Widerlager 190 verhindern, daß sich die Basisleiterplatte 50 beim Schließen der PC-Bus-Steckverbindung durchbiegt oder bricht. Ein an einem Gehäusedeckel 200 befestigter Bügel 210 verhindert ein Ausweichen der Leiterplatte 10 beim Einstecken von weiteren Leiterplatten 20 in eine der Steckeraufnahmen 30.

Bei der in der Figur 1 gezeigten Ausführungsform der steckbaren Leiterplatte 10 ist kein Antriebsmechanismus zum Verschieben des Leiterplattenteiles 70 vorgesehen. Das bedeutet, daß zum manuellen Verschieben des Leiterplattenteiles 70 ein Entfernen des Gehäuses notwendig ist.

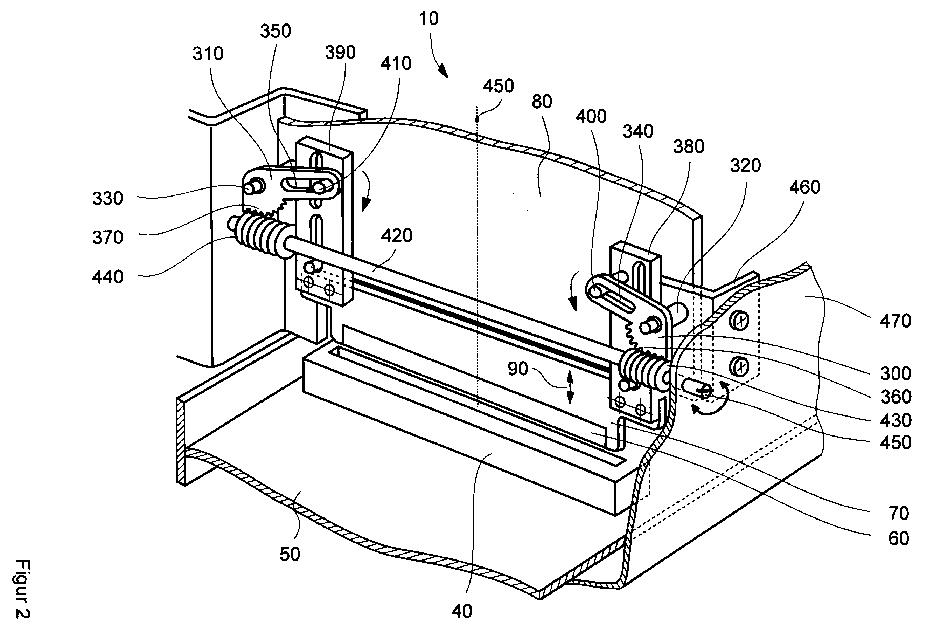

Figur 2 zeigt die steckbare Leiterplatte 10 mit dem verschiebbaren Leiterplattenteil 70, das die Steckkontaktanordnung 60 trägt, und dem übrigen Leiterplattenteil 80, ergänzt durch einen im folgenden erläuterten Antriebsmechanismus in Form eines Schneckengetriebes. Weitere auf der Leiterplatte 10 aufgesteckte Leiterplatten sind aus Gründen der Übersichtlichkeit nicht eingezeichnet.

Auf dem übrigen Leiterplattenteil 80 sind ein erster Stellhebel 300 sowie ein zweiter Stellhebel 310 gelagert und in einer Ebene parallel zur Leiterplattenebene drehbar. Als Lager dient ein senkrecht auf dem Leiterplattenteil 80 angeordneter erster Bolzen 320 bzw. zweiter Bolzen 330. Der erste Stellhebel 300 hat ein erstes Langloch 340 und ein erstes Zahnradsegment 360 und der zweite Stellhebel 310 ein zweites Langloch 350 und ein zweites Zahnradsegment 370.

Der verschiebbare Leiterplattenteil 70 ist mit dem übrigen Leiterplattenteil 80 über eine erste Verbindungsplatte 380 und eine zweite Verbindungsplatte 390 verbunden. Ein auf der ersten Verbindungsplatte 380 angeordneter erster Stift 400 greift in das erste Langloch 340. Ebenso greift ein auf der zweiten Verbindungsplatte 390 angeordneter zweiter Stift 410 in das zweite Langloch 350.

Auf einer Welle 420 sitzt eine erste Schnecke 430 und eine zweite Schnecke 440. Die erste Schnecke 430 greift in das erste Zahnradsegment 360, die zweite Schnecke 440 in das zweite Zahnradsegment 370. Aufgrund der zur Mittellinie 450 der Leiterplatte 10 spiegelsymmetrischen Anordnung der Stellhebel 360 und 370 ist die Verwendung von zwei gegenläufigen Schnecken notwendig. In diesem Beispiel ist die erste Schnecke 430 linksgängig und die zweite Schnecke 440 rechtsgängig. Wird die Welle 420 im Uhrzeigersinn gedreht, dreht sich der erste Stellhebel 300 gegen den Uhrzeigersinn und der zweite Stellhebel 310 im Uhrzeigersinn. Der verschiebbare Leiterplattenteil 80 wird in Richtung der PC-Bus-Steckeraufnahme 40 geführt und die Steckverbindung geschlossen.

Eine Stirnseite 450 der Welle 420 ist gekerbt, um die Welle 420 z.B. mit einem Schraubendreher drehen zu können. Der übrige Leiterplattenteil 80 ist mit Hilfe eines Winkelelementes 460 mit einem Gehäusesegment 470 verschraubt, so daß der übrige Leiterplattenteil 80 auch bei gelöster Steckverbindung seine Lage nicht verändert.

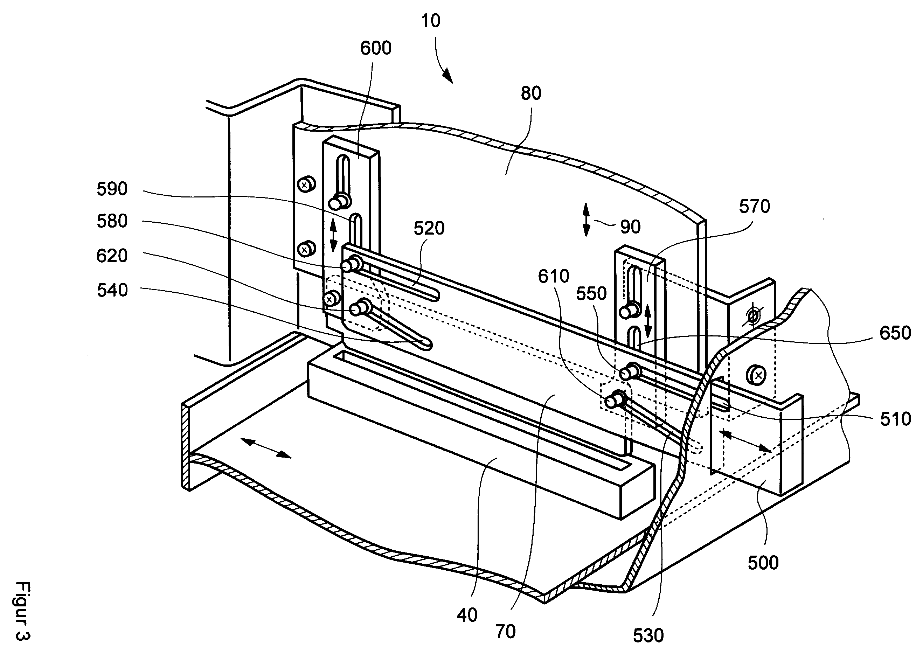

Figur 3 zeigt die steckbare Leiterplatte 10 mit dem verschiebbaren Leiterplattenteil 70, ergänzt durch einen im folgenden erläuterten Antriebsmechanismus. Eine Schubstange 500 enthält Langlöcher 510 und 520 und Führungsbahnen 530 und 540.

Die Langlöcher 510, 520 sind senkrecht zur Steckrichtung angeordnet. Ein erster Bolzen 550 greift in das Langloch 510 der Schubstange 500 und in ein Langloch 560 einer ersten Verbindungsplatte 570. Entsprechend greift ein zweiter Bolzen 580 in ein Langloch 520 der Schubstange 500 und in ein Langloch 590 einer zweiten Verbindungsplatte 600. Die Bolzen 550, 580 sind mit dem übrigen Leiterplattenteil 80 fest verbunden.

Die Führungsbahnen 530, 540 verlaufen schräg zu den Langlöchern 510, 520 und bilden eine Steuerrampe. Ein erster Führungsstift 610 greift in die Führungsbahn 530 und ist mit dem verschiebbaren Leiterplattenteil 70 fest verbunden.

Entsprechend greift ein zweiter Führungsstift 620 in die Führungsbahn 540 und ist ebenfalls mit dem verschiebbaren Leiterplattenteil 70 fest verbunden. Die Führungsbahnen 530, 540 haben gleichförmige Steigungen, so daß der verschiebbare Leiterplattenteil 70 über seine gesamte Länge gleichmäßig und linear in Steckrichtung bewegt wird.

Die Ausführungsbeispiele zeigen, daß die Erfindung den Zeitaufwand für den Austausch der Basisleiterplatte 50 reduziert, weil ein Aus- und Einbau der weiteren Leiterplatten 20 nicht mehr notwendig ist. Ferner wird der Vorgang so vereinfacht, daß besondere Fachkenntnisse nicht mehr erforderlich sind. Das bedeutet, daß auch ein Benutzer des Rechner den Austausch ohne die Hilfe eines Servicetechnikers vornehmen kann.

## Patentansprüche

1. Steckbare Leiterplatte (10) mit einer längs einer ihrer Kanten vorgesehenen Steckkontaktanordnung (60) dadurch **gekennzeichnet**, daß ein die Steckkontaktanordnung (60) tragender Abschnitt der Leiterplatte (10) einen relativ zu dem übrigen Teil der Leiterplatte in Steckrichtung (90) verschiebbaren Leiterplattenteil (70) bildet, der mit dem übrigen Teil (80) der Leiterplatte (10) über eine Schiebevorrichtung und über eine flexible Leiterbahnanordnung (110) verbunden ist.

2. Steckbare Leiterplatte (10) nach Anspruch 1, dadurch **gekennzeichnet**, daß die Schiebevorrichtung eine erste und eine zweite Schiebeführung enthält, die das verschiebbare Leiterplattenteil (70) mit dem übrigen Leiterplattenteil (80) verbinden.

3. Steckbare Leiterplatte (10) nach Anspruch 2, dadurch **gekennzeichnet**, daß die Schiebeführungen jeweils eine Verbindungsplatte (380, 390) haben, die mindestens zwei in Steckrichtung weisende Langlöcher enthält, in denen jeweils ein auf dem übrigen Leiterplattenteil (80) stehender Bolzen sitzt.

4. Steckbare Leiterplatte (10) nach Anspruch 3, **gekennzeichnet** durch einen ersten zweiarmigen Hebel (300) und einen zweiten zweiarmigen Hebel (310), die in einer Ebene parallel zur Leiterplattenebene drehbar gelagert sind und die mit je einem ersten Hebelarm mit einem auf der ersten bzw. zweiten Verbindungsplatte (380, 390) angeordnetem Stift (400, 410) in Eingriff stehen, und durch eine Gelenkstange, die die zweiten Hebelarme miteinander verbindet.

5. Steckbare Leiterplatte (10) nach Anspruch 4, dadurch **gekennzeichnet**, daß die Stifte in Langlöchern des jeweils ersten Hebelarmes des ersten bzw. zweiten Hebels sitzen, und
daß die Langlöcher der ersten Hebelarme in Richtung der Lagerung des jeweiligen Hebels weisen.

6. Steckbare Leiterplatte (10) nach Anspruch 3, **gekennzeichnet** durch einen ersten und einen zweiten Stellhebel (300, 310) mit je einem Langloch (340, 350) und einem Zahnradsegment (360, 370), wobei die Stellhebel (300, 310) auf der Leiterplatte gelagert und in einer Ebene parallel zur Leiterplattenebene drehbar sind, und durch zwei auf den Verbindungsplatten (380, 390) angeordnete Stifte (400, 410), die in das jeweilige Langloch (340, 350) des ersten bzw. zweiten Stellhebels (300, 310) eingreifen.

7. Steckbare Leiterplatte (10) nach Anspruch 6, dadurch **gekennzeichnet**, daß ein erstes Lager (320) des ersten Stellhebels (300) und ein zweites Lager (330) des zweiten Stellhebels (310) zwischen der dieses Tragenden Verbindungsplatte (380, 390) und der jeweiligen Außenkante der steckbaren Leiterplatte (10) liegt, die parallel zur Steckrichtung (90) verläuft.

8. Steckbare Leiterplatte (10) nach Anspruch 7, **gekennzeichnet** durch eine bei dem übrigen Leiterplattenteil (80) gelagerte Welle (420), deren Drehachse parallel zur Leiterplattenebene und senkrecht zur Steckrichtung (90) liegt,
und durch zwei auf der Welle (420) sitzende Schnecken (440, 450), die in die Zahnradsegmente (360, 370) des ersten bzw. zweiten Stellhebels (300, 310) greifen.

9. Steckbare Leiterplatte (10) nach Anspruch 3, **gekennzeichnet** durch jeweils ein an der ersten bzw. zweiten Verbindungsplatte befestigtes, im wesentlichen senkrecht zur Leiterplatte stehendes Lager für je eine Scheibe, die exzentrisch auf einer Welle sitzt, wobei die Längsachse der Welle im wesentlichen senkrecht zur Steckrichtung (90) und in einer Ebene parallel zur Leiterplattenebene liegt.

10. Steckbare Leiterplatte (10) nach Anspruch 9, **gekennzeichnet** durch ein Zahnradgetriebe, das an einem Ende der Welle sitzt.

11. Steckbare Leiterplatte (10) nach Anspruch 3. **gekennzeichnet** durch eine Schubstange (500) mit zwei Langlöchern (510, 520), die senkrecht zur Steckrichtung (90) verlaufen, wobei jeweils einer der auf dem übrigen Teil (80) der Leiterplatte (10) angeordneten Bolzen (550, 580) in einem Langloch (560, 590) der Verbindungsplatte (570, 600) und in einem Langloch (510, 520) der Schubstange (500) sitzt, wobei die Schubstange (500) zwei rampenförmig ausgebildete Führungsbahnen (530, 540) enthält, und
durch je einen auf der ersten bzw. zweiten Verbindungsplatte (570, 600) angeordneten Stift (610, 620), der in jeweils einer der rampenförmig ausgebildeten Führungsbahnen (530, 540) eingreift.

12. Steckbare Leiterplatte nach einem der vorhergehenden Ansprüche, dadurch **gekennzeichnet**, daß die flexible Leiterbahnanordnung ein Flachbandkabel (110) ist.

13. Steckbare Leiterplatte nach einem der vorhergehenden Ansprüche, dadurch **gekennzeichnet**, daß die Steckeranordnung ein PC-Bus-Stecker ist.

14. Steckbare Leiterplatte nach einem der vorhergehenden Ansprüche, dadurch **gekennzeichnet**, daß sich auf der steckbaren Leiterplatte mindestens eine Vorrichtung zur Steckeraufnahme (30) befindet.

15. Steckbare Leiterplatte nach einem der vorhergehenden Ansprüche, dadurch **gekennzeichnet**, daß der übrige Leiterplattenteil eine Befestigungsvorrichtung enthält.
